# EUROPEAN PATENT SPECIFICATION

(11) **EP 1 384 286 B1**
(45) Date of publication and mention of the grant of the patent: **14.06.2006**
(21) Application number: 02718445.6
(22) Date of filing: 09.04.2002
(51) Int. Cl.: H01Q 9/04

(54) **INVERTED-F FERROELECTRIC ANTENNA**
INVERTED-F FERROELEKTRISCHE ANTENNE
ANTENNE FERROELECTRIQUE INVERSEE EN F

(30) Priority: 11.04.2001 US 283093 P; 13.07.2001 US 904631; 24.07.2001 US 912753; 08.08.2001 US 927732; 10.08.2001 US 927136
(43) Date of publication of application: 28.01.2004
(73) Proprietor: Kyocera Wireless Corp., San Diego, CA 92121 (US)
(72) Inventor: FABREGA-SANCHEZ, Jordi, San Diego, CA 92109 (US)
(74) Representative: Viering, Jentschura & Partner
(86) International application number: PCT/IB2002/001120
(87) International publication number: WO 2002/084798

(56) References cited:
- WO-A-00/28613
- WO-A-00/62367
- US-A- 4 475 108
- US-A- 2001 043 159
- LOUHOS J-P, PANKINAHO I: "Electrical Tuning of integrated mobile phone antennas" PROCEEDINGS OF 1999 ANTENNA APPLICATIONS SYMPOSIUM, MONTICELLO, IL, USA, 15-17 SEPT. 1999, pages 69-97, XP001083954 Amherst, MA, USA
- PANAYI P K, AL-NUAIMI M, IVRISSIMTZIS L P: "Tuning techniques for the planar inverted-F antenna" IEE NATIONAL CONFERENCE ON ANTENNAS AND PROPAGATION (IEE CONF. PUBL. NO. 461), 31 MARCH-1 APRIL 1999, XP001084147 York, UK

## Description

### BACKGROUND OF THE INVENTION

### 1. Field of the Invention

This invention generally relates to wireless communication antennas and, more particularly, to an inverted-F antenna that is tuned using a ferroelectric capacitor.

### 2. Description of the Related Art

There are several types of conventional antenna designs that incorporate the use of a dielectric material. Generally speaking, a portion of the field that is generated by the antenna returns to the counterpoise (ground), from the radiator, through the dielectric. The antenna is tuned to be resonant at frequencies, and the wavelengths of the radiator and dielectrics have an optimal relationship at the resonant frequency. The most common dielectric is air, with a dielectric constant of 1. The dielectric constants of other materials are defined with respect to air.

Ferroelectric materials have a dielectric constant that changes in response to an applied voltage. Because of their variable dielectric constant, ferroelectric materials are good candidates for making tunable components. Under presently used measurement and characterization techniques, however, tunable ferroelectric components have gained the reputation of being consistently and substantially lossy, regardless of the processing, doping or other fabrication techniques used to improve their loss properties. They have therefore not been widely used. Ferroelectric tunable components operating in RF or microwave regions are perceived as being particularly lossy. This observation is supported by experience in Radar applications where, for example, high radio frequency (RF) or microwave loss is the conventional rule for bulk (thickness greater than about 1.0 mm) FE (ferroelectric) materials especially when maximum tuning is desired. In general, most FE materials are lossy unless steps are taken to improve (reduce) their loss. Such steps include, but are not limited to: (1) pre and post deposition annealing or both to compensate for O₂ vacancies, (2) use of buffer layers to reduce surfaces stresses, (3) alloying or buffering with other materials and (4) selective doping.

As demand for limited range tuning of lower power components has increased in recent years, the interest in ferroelectric materials has turned to the use of thin film rather than bulk materials. The assumption of high ferroelectric loss, however, has carried over into thin film work as well. Conventional broadband measurement techniques have bolstered the assumption that tunable ferroelectric components, whether bulk or thin film, have substantial loss. In wireless communications, for example, a Q of greater than 80, and preferably greater than 180 and, more preferably, greater than 350, is necessary at frequencies of about 2 GHz. These same assumptions apply to the design of antennas.

Tunable ferroelectric components, especially those using thin films, can be employed in a wide variety of frequency agile circuits. Tunable components are desirable because they can provide smaller component size and height, lower insertion loss or better rejection for the same insertion loss, lower cost and the ability to tune over more than one frequency band. The ability of a tunable component that can cover multiple bands potentially reduces the number of necessary components, such as switches that would be necessary to select between discrete bands were multiple fixed frequency components used. These advantages are particularly important in wireless handset design, where the need for increased functionality and lower cost and size are seemingly contradictory requirements. With code division multiple access (CDMA) handsets, for example, performance of individual components is highly stressed. Ferroelectric (FE) materials may also permit integration of RF components that to-date have resisted shrinkage, such as an antenna interface unit (AIU) for a wireless device.

It is known to use a so-called inverted-F antenna design in the fabrication of portable wireless communication devices. The inverted-F design permits an antenna to be made in a relatively small package. Many conventional wireless devices operate in several frequency bands. Even if each antenna is small, the total amount of space required for several antennas (one for each frequency band) can be prohibitive.

The paper "Electrical tuning of integrated mobile phone antennas" by Juha-Pekka Louhos et al., Proceedings of 1999 Antenna Applications Symposium, Monticello, IL, USA, 15-17 September 1999, describes the enhancement of the impedance bandwidth of a PIFA antenna by changing the reactive loading of the resonator either by means of a PIN diode or a varactor diode.

The document WO 00/28613 describes a tunable dielectric varactor including a tunable ferroelectric layer and first and second non-tunable dielectric layers.

It would be advantageous if a single antenna could be used for portable wireless communications in a plurality of frequency bands.

It would be advantageous if an inverted-F antenna could be made tunable to operate over a plurality of frequency bands.

It would be advantageous if ferroelectric material could be used in tuning an inverted-F antenna.

### SUMMARY OF THE INVENTION

The present invention describes an inverted-F antenna that is tuned to operate over a plurality of frequency bands by using a ferroelectric material as a dielectric. More specifically, a FE capacitor is used to modify the electrical length of the inverted-F radiator.

Accordingly, an inverted-F ferroelectric antenna is provided as defined in claim 1

Additional details of the above-described inverted-F ferroelectric antenna are provided below.

### BRIEF DESCRIPTION OF THE DRAWINGS

Fig. 1 is a plan view of an inverted-F ferroelectric antenna.
Fig. 2 is a partial cross-sectional view of the antenna of Fig. 1.
Fig. 3 is a plan view of the antenna of Fig. 1 showing components underlying the radiator.
Figs 4a, 4b, 4c, and 4d illustrate the first capacitor embodied as parallel plate and gap capacitors.
Figs. 5a and 5b illustrate different aspects of the first capacitor of Figs. 4a and 4b, respectively.
Figs. 6a and 6b illustrate other aspects of the first capacitor of Figs. 4a and 4b, respectively.
Fig. 7 is a partial cross-sectional view of the antenna of the present invention.

### DETAILED DESCRIPTION OF THE PREFERRED EMBODIMENTS

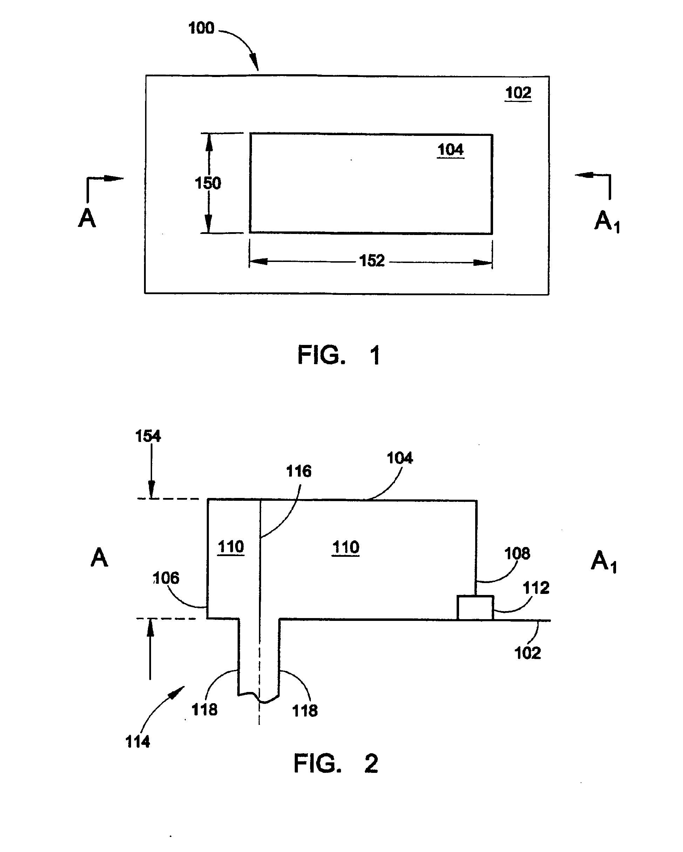

Fig. 1 is a plan view of the present invention inverted-F ferroelectric antenna. The antenna 100 comprises a counterpoise 102 in a first plane and an inverted-F structure radiator 104 overlying the counterpoise 102 in a second plane. The inverted-F antenna is a type of patch antenna.

Fig. 2 is a partial cross-sectional view of the antenna of Fig. 1. The radiator 104 has a first end 106 connected to the counterpoise 102 and a second end 108. A first dielectric 110 is interposed between the radiator 104 and the counterpoise 102. Typically, the first dielectric is air or a ceramic material, such as Alumina. However, FR4, foam, MgO, lanthanum aluminate, and sapphire can also be used. The present invention antenna is not limited to just this list of materials, as there are many conventional dielectric materials that are practical.

A first capacitor 112 is formed from a dielectric with ferroelectric material, having a variable dielectric constant, interposed between the radiator second end 108 and the counterpoise 102. The antenna 100 is resonant at a frequency responsive to the dielectric constant of the first capacitor 112 ferroelectric material. The combination of the first capacitor 112 and the radiator 104 have an effective electrical wavelength of a quarter-wavelength of the resonant frequency.

A radio frequency (RF) antenna interface 114 connects the radiator 104 to a transmission line first polarity 116 and connects the counterpoise 102 to the transmission line second polarity 118. The antenna interface 114 has a predetermined fixed characteristic impedance independent of the resonant frequency. Typically, the antenna interface 114 is designed to be 50 ohms with a voltage standing wave ration (VSWR) or less than 2:1 at the operating frequency. Alternately stated, the antenna interface has a return loss of greater than approximately 10 decibels (dB). The antenna interface 114 can be designed to interface with a microstrip, stripline, coaxial, or any convention transmission line.

The antenna 100 has a predetermined approximately constant gain independent of the resonant frequency. In some aspects, the first capacitor is used to make relatively large shifts in antenna operating frequency, between frequency bands. Alternately, the first capacitor is used to shift between narrow channels frequencies within the same frequency band.

In some aspects, the first capacitor includes a dielectric formed exclusively from a ferroelectric material with a variable dielectric constant. That is, the capacitor is made with only FE dielectric material, so that changes in dielectric constant, and therefore capacitance, result from bias voltage changes. The first capacitor FE dielectric can have a dielectric constant in the range between 100 and 5000 at zero volts.

In other aspects, the dielectric constant of ferroelectric materials is too high. Then, the first capacitor 112 is typically formed from an additional dielectric, a material with a fixed dielectric constant (fixed constant dielectric). The material can be a ceramic, FR4, air, foam, MgO, lanthanum aluminate, or sapphire, to name a few examples. Many other conventional fixed dielectric materials are also practical. Therefore, first capacitor includes a dielectric formed from a ferroelectric material (ferroelectric dielectric) with a variable dielectric constant, together with a fixed constant dielectric material.

However, the composite dielectric constant resulting from the first capacitor being formed from a fixed constant dielectric material, as well as the ferroelectric dielectric, is in the range between 2 and 100 at zero volts.

Typically, first capacitor FE dielectric material is formed from barium strontium titanate, BaₓSr₁₋ₓTiO₃ (BSTO). The BSTO ferroelectric material may include oxide dopants of tungsten, manganese, or magnesium. Depending upon the FE material dielectric constant and the FE material thickness, first capacitor can be fabricated with a FE dielectric having a dielectric constant that doubles in response to a change of less than 1 volt of bias voltage.

In some aspects, the antenna can be tuned to operate at PCS frequencies in the range from 1850 to 1990 megahertz (MHz). Then, the radiator has a width 150 (see Fig. 1) of 5.9 millimeters (mm) and a length 152 of 16 mm. The radiator has a height 154 (see Fig. 2) of 6.5 mm. In this example, the first dielectric 110 is air and the first capacitor 112 has a capacitance of approximately 0.35 picofarads (pF) at zero volts of bias voltage. At 40 volts of bias voltage, the first capacitor 112 has a capacitance of approximately 0.29 pf. -

More generally, the first capacitor 112 can be fabricated to have a capacitance in the range of 0.1 to 10 pf at zero volts, although the first capacitor is not necessarily limited to this range. Other practically obtainable frequency bands are 824 to 894 MHz and 1565 to 1585 MHz.

In some aspects, the first capacitor FE dielectric is formed in a thin film having a thickness in the range from 0.15 to 2 microns. In other aspects, the FE dielectric is formed in a thick film having a thickness in the range from 1.5 to 1000 microns.

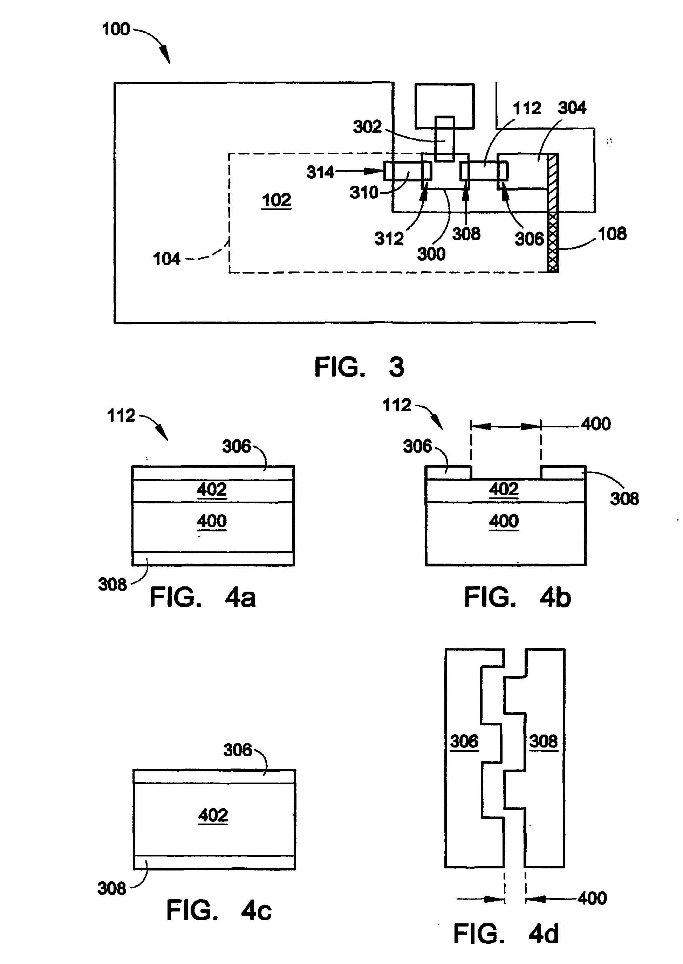

Fig. 3 is a plan view of the antenna of Fig. 1 showing components underlying the radiator 104. A bias voltage feed 300 applies a voltage to the first capacitor 112 with the ferroelectric material. A resistor 302 is used to supply voltage (current) to the voltage feed 300, and the voltage feed 300 supplies voltage (current) to the first capacitor 112. Additional filtering may also be connected to the voltage feed 300 to shunt RF signal to ground. The other end of the first capacitor 112 is connected to a pad 304, and connected in turn to the radiator second end 108, in the area of hatched lines. Note that the radiator second end 108 is not connected to the underlying counterpoise 102, in the area of cross-hatched lines. An air gap or solid dielectric spacer separates the radiator second end 108 from the underlying counterpoise 102. Since the radiator is typically a dc ground, a dc voltage is developed across the first FE capacitor 112. The FE dielectric has a dielectric constant that varies in response to the applied voltage.

The first capacitor 112 has a first terminal 306 connected to the radiator second end 118 and a second terminal 308 connected to the voltage feed 300. The bias voltage feed 300 applies a first voltage potential across the first capacitor 112.

Figs 4a, 4b, 4c, and 4d illustrate the first capacitor 112 embodied as parallel plate and gap capacitors. As seen in Fig. 4a, the first capacitor 112 is a parallel plate capacitor having the first terminal 306 formed as a plate, overlying a layer of FE dielectric 402, overlying a layer of fixed constant dielectric 400, overlying the second terminal 308 formed as a plate.

As seen in Fig. 4b, the first capacitor 112 is a gap capacitor having the first and second terminals 306/308 formed as pads, separated by a gap 404, overlying a layer of FE dielectric 402. The layer of FE dielectric 402 overlies a layer of fixed constant dielectric 400.

Alternately stated, the first capacitor 112 includes at least one fixed constant dielectric layer 400 and a FE dielectric 402, having a variable dielectric constant, adjacent the fixed constant dielectric 400. There are a variety of other approaches, not specifically shown, that can be used to combine regions of FE dielectric with regions of fixed constant dielectric material to provide the desired composite dielectric constant.

As seen in Fig. 4b the ferroelectric dielectric 402 can be interposed between the fixed constant dielectric 400 and the terminals 306/308. Alternately but not shown, the fixed constant dielectric is interposed between the FE dielectric and the terminals.

Fig. 4c illustrates a first parallel plate capacitor 112 where the dielectric is formed exclusively from a ferroelectric material.

Fig. 4d is a plan view an interdigital variation of the first gap capacitor 112.

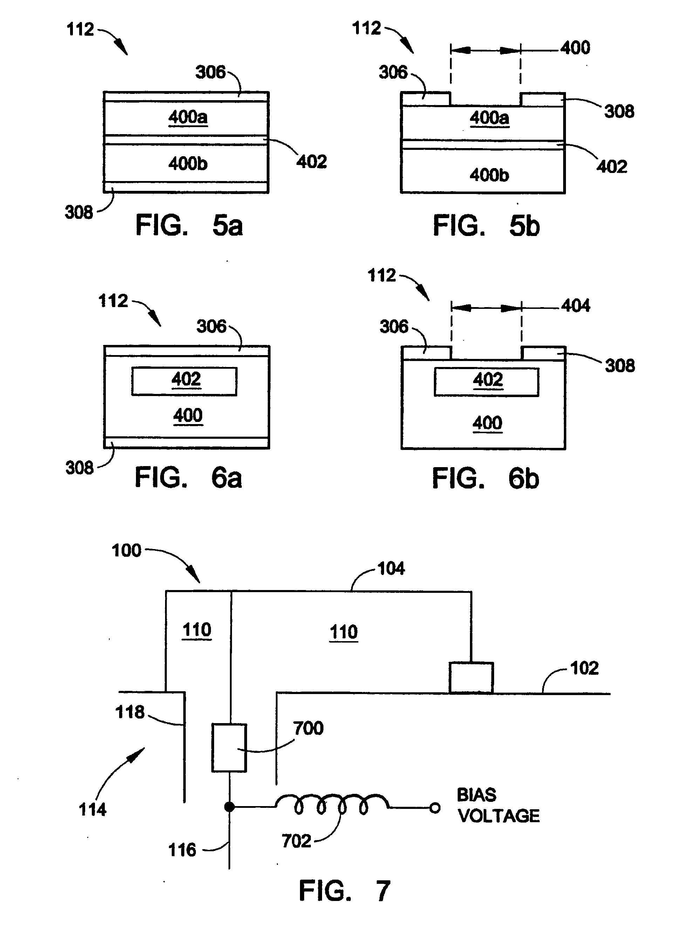

Figs. 5a and 5b illustrate different aspects of the first capacitor 112 of Figs. 4a and 4b, respectively. The first capacitor 112 fixed constant dielectric forms a first layer 400b underlying the FE dielectric 402, and a second layer 400a overlying the FE dielectric 402.

Figs. 6a and 6b illustrate other aspects of the first capacitor 112 of Figs. 4a and 4b, respectively. Here the ferroelectric dielectric 402 is formed internal to the fixed constant dielectric 400. Likewise but not shown, the ferroelectric dielectric 402 can be formed external to the fixed constant dielectric 400.

Returning to Fig. 3, a bias voltage blocking capacitor 310 is seen interposed between the first capacitor second terminal and the counterpoise. The blocking capacitor acts as an ac (RF) short. With respect to the PCS antenna example presented above, a 200 pf capacitance value is practical. In other aspects of the antenna, the capacitance of the blocking capacitor 310 can be reduced so that it can be used as a tuning element in series with first capacitor 112. The blocking (non-FE) capacitor has a capacitance that remains constant, while first capacitor 112 has a capacitance that varies in response to the bias voltage.

In some aspects of the invention, capacitor 310 is a second capacitor formed from a dielectric with ferroelectric material having a variable dielectric constant, equivalent to the first capacitor 112 described above. The second capacitor 310 has a first terminal 312 connected to the first capacitor second terminal 308 (the bias voltage feed 300) and a second terminal 314 connected to the counterpoise 102.. The bias voltage feed 300 applies a voltage potential across the second capacitor 310. Then, the antenna 100 is resonant at a frequency responsive to the dielectric constant of the second capacitor 310 ferroelectric dielectric, in (series) combination with the first capacitor 112 ferroelectric dielectric.

Fig. 7 is a partial cross-sectional view featuring an additional aspect of the antenna 100 of Fig. 2. In some aspects of the antenna, when the antenna is being tuned across an extremely wide range of frequencies, it may not be practical to maintain the antenna interface 114 at a constant impedance. Then, a third FE capacitor, equivalent to the first FE capacitor 112 described above, can be used to tune the mismatch between the antenna interface 114 and the transmission line. The third capacitor 700 is formed from a ferroelectric dielectric, having a variable dielectric constant, interposed between the transmission line first polarity 116 and the radiator 104. The characteristic impedance of the transmission line 1161118 (as measured from the antenna interface 114) is responsive to the dielectric constant of the third capacitor 700 ferroelectric dielectric. The voltage bias is shown connected to the third capacitor 700 via an inductive choke 702. Alternately but not shown, a resistor can be used instead of the choke 702.

## Claims

1. An inverted-F ferroelectric antenna comprising:
a counterpoise (102, 1002);
an inverted-F structure radiator (104, 1004) having a first end (106, 1006) connected to the counterpoise (102, 1002) and a second end (108, 1008);
a first dielectric (110, 1000) interposed between the radiator (104, 1004) and the counterpoise (102, 1002);
**characterized by** a first capacitor (112, 1012) formed from a second dielectric (400, 402) with a first ferroelectric material (402), having a first variable dielectric constant, interposed between the radiator second end (108, 1008) and the counterpoise (102, 1002);
wherein the antenna (100) is resonant at a resonant frequency responsive to the first variable dielectric constant of the first ferroelectric material (402);
a transmission line having a transmission line first polarity (116) connected to the radiator (104, 1004), the transmission line having a predetermined fixed characteristic impedance independent of the resonant frequency of the antenna (100);
a second capacitor (700) formed from a third dielectric with a second ferroelectric material (402), having a second variable dielectric constant, interposed between the transmission line first polarity (116) and the radiator (104); and
wherein an adjustable impedance, looking toward the transmission line, as seen from the radiator (104), is responsive to the second variable dielectric constant of the second ferroelectric material (402).

2. The antenna (100) of claim 1 wherein the antenna (100) has a predetermined approximately constant gain independent of the resonant frequency.

3. The antenna of claim 1 wherein the second dielectric (400,402) of the first capacitor (112, 1012) includes:
a fourth dielectric (400) formed from a fixed dielectric material with a fixed dielectric constant.

4. The antenna (100) of claim 1 further comprising:
a bias voltage feed (300) for applying an applied voltage to the first capacitor (112, 1012); and,
wherein the first variable dielectric constant of the first ferroelectric material (402) varies in response to the applied voltage.

5. The antenna (100) of claim 4 wherein the first ferroelectric material (402) has a first variable dielectric constant in the range between 100 and 5000 at zero volts.

6. The antenna (100) of claim 5 4 wherein the fixed dielectric material (400) and the ferroelectric material (402) have a composite dielectric constant in the range between 2 and 100 at zero volts.

7. The antenna (100) of claim 4 3 wherein the fixed dielectric material (400) is formed from a material selected from the group including ceramic, FR4, air, foam, MgO, lanthanum aluminate, and sapphire.

8. The antenna (100) of claim 5- 4 wherein the first ferroelectric material (402) is formed from barium strontium titanate, BaₓSr₁₋ₓ, TiO₃ (BSTO) .

9. The antenna (100) of claim 8 wherein the first ferroelectric material (402) includes oxide dopants selected from the group including tungsten, manganese, and magnesium.

10. The antenna (100) of claim 8 wherein the first variable dielectric constant that doubles in response to a change of less than 1 volt of a bias voltage.

11. The antenna (100) of claim 8 wherein the first capacitor (112, 1012) has a capacitance of approximately 0.35 picofarads (pF) at zero volts of a bias voltage.

12. The antenna (100) of claim 11 wherein the first capacitor (112, 1012) has a capacitance of approximately 0.29 pf at 40 volts of bias voltage.

13. The antenna (100) of claim 8 wherein the first capacitor (112, 1012) has a capacitance in the range of 0.1 to 10 pf at zero volts.

14. The antenna (100) of claim 4 wherein the first ferroelectric material (402) is formed in a thin film having a thickness in the range from 0.15 to 2 microns.

15. The antenna (100) of claim 4 wherein the first ferroelectric material (402) is formed in a thick film having a thickness in the range from 1.5 to 1000 microns.

16. The antenna (100) of claim 4 wherein the first capacitor (112, 1012) has a first terminal (306) connected to the radiator second end (108, 1008) and a second terminal (308) connected to the bias voltage feed (300); and,
wherein the bias voltage feed (300) applies a first voltage potential across the first capacitor (112, 1012).

17. The antenna (100) of claim 16 wherein the first capacitor (112, 1012) includes:
a first fixed constant dielectric layer (400); and,
a ferroelectric dielectric (402) with a variable dielectric constant, adjacent the first fixed constant dielectric layer (400).

18. The antenna (100) of claim 17 wherein the first ferroelectric material (402) is interposed between the first fixed constant dielectric layer (400) and the terminals (306, 308) .

19. The antenna (100) of claim 17 wherein the first fixed constant dielectric material (400a) is interposed between the ferroelectric material (402) and the first terminal (306), and a second fixed constant dielectric layer (400b) is interposed between the second terminal (308) and the ferroelectric material (402).

20. The antenna (100) of claim 17 wherein the first ferroelectric material (402) is formed internal to the first fixed constant dielectric (400).

21. The antenna (100) of claim 17 wherein the first ferroelectric material (402) is formed external to the first fixed constant dielectric layer (400).

22. The antenna (100) of claim 16 further comprising:
a bias voltage blocking capacitor (310) interposed between the first capacitor second terminal (308) and the counterpoise (102, 1002).

23. The antenna (100) of claim 16 wherein the first capacitor (112, 1012) is a gap capacitor having the first and second terminals (306, 308) formed as pads, separated by a gap, overlying a layer of ferroelectric dielectric.

24. The antenna (100) of claim 23 wherein the first capacitor (112, 1012) includes the layer of ferroelectric dielectric (402) overlying a layer (400) of fixed constant dielectric.

25. The antenna (100) of claim 16 wherein the first capacitor (112, 1012) is a parallel plate capacitor having the first terminal (306) formed as a plate, overlying a layer of ferroelectric dielectric (402), overlying a layer (400) of fixed constant dielectric, overlying the second terminal (308) formed as a plate.

26. The antenna (100) of claim 16 further comprising:
a third capacitor (310) formed from a fifth dielectric (400,402) with a third ferroelectric material (402) having a third variable dielectric constant, with a third capacitor first terminal (312) connected to the first capacitor second terminal (308) and a third capacitor second terminal (314) connected to the counterpoise (102, 1002);
wherein the bias voltage feed (300) applies a voltage potential across the second capacitor (310); and,
wherein the antenna (100) is resonant at the resonant frequency responsive to the third variable dielectric constant of the third ferroelectric material (402) in combination with the first variable dielectric constant of the first capacitor ferroelectric material (402).

27. The antenna (100) of claim 1 wherein the combination of the first capacitor (112, 1012) and the radiator (104, 1004) have an effective electrical wavelength of a quarter-wavelength of the resonant frequency.

28. The antenna (100) of claim 1 wherein the first dielectric (110, 1000) is formed from a material selected from the group including ceramic, FR4, air, foam, MgO, lanthanum aluminate, and sapphire.

29. The antenna (100) of claim 1 wherein the second dielectric is formed exclusively from the ferroelectric material (402) .

## Patentansprüche

1. Inverted-F ferroelektrische Antenne mit:
einem Gegengewicht (102, 1002);
einem Strahler (104, 1004) mit Inverted-F-Struktur mit einem ersten Ende (106, 1006), das mit dem Gegengewicht (102, 1002) gekoppelt ist, und einem zweiten Ende (108, 1008);
einem ersten Dielektrikum (110, 1000), das zwischen dem Strahler (104, 1004) und dem Gegengewicht (102, 1002) angeordnet ist;
**gekennzeichnet durch**
eine erste Kapazität (112, 1012), die mit einem ersten ferroelektrischen Material (402) aus einem zweiten Dielektrikum (400, 402) gebildet ist, mit einer ersten veränderlichen dielektrischen Konstante, die zwischen dem zweiten Ende (108, 1008) des Strahlers und dem Gegengewicht (102, 1002) angeordnet ist;
wobei die Antenne (100) bei einer Resonanzfrequenz resonant ist, die auf die erste veränderliche dielektrische Konstante des ersten ferroelektrischen Materials (402) reagiert;
einer Übertragungsleitung mit einer ersten Polarität (116) der Übertragungsleitung, die mit dem Strahler (104, 1004) gekoppelt ist, wobei die Übertragungsleitung eine vorgegebene feste charakteristische Impedanz aufweist, die von der Resonanzfrequenz der Antenne (100) unabhängig ist;
eine zweite Kapazität (700), die mit einem zweiten ferroelektrischen Material (402) aus einem dritten Dielektrikum gebildet ist, mit einer zweiten veränderlichen dielektrischen Konstante, die zwischen der Übertragungsleitung mit erster Polarität (116) und dem Strahler (104) angeordnet ist; und
wobei eine einstellbare Impedanz, die von dem Strahler (104) aus gesehen auf die Übertragungsleitung sieht, auf die zweite veränderliche dielektrische Konstante des zweiten ferroelektrischen Materials (402) reagiert.

2. Antenne (100) gemäß Anspruch 1, wobei die Antenne (100) eine vorgegebene ungefähr konstante Verstärkung aufweist, die von der Resonanzfrequenz unabhängig ist.

3. Antenne gemäß Anspruch 1, wobei das zweite Dielektrikum (400, 402) der ersten Kapazität (112, 1012) aufweist:
ein viertes Dielektrikum (400), das aus einem unveränderlichen dielektrischen Material mit einer unveränderlichen dielektrischen Konstante gebildet ist.

4. Antenne (100) gemäß Anspruch 1, ferner aufweisend:
eine Bias-Spannungseinspeisung (300) zum Anlegen einer angelegten Spannung an die erste Kapazität (112, 1012); und
wobei sich die erste veränderliche dielektrische Konstante des ersten ferroelektrischen Materials (402) in Antwort auf die angelegte Spannung ändert.

5. Antenne (100) gemäß Anspruch 4, wobei das erste ferroelektrische Material (402) eine erste veränderliche dielektrische Konstante in dem Bereich zwischen 100 und 5000 bei Null Volt aufweist.

6. Antenne (100) gemäß Anspruch 4, wobei das unveränderliche dielektrische Material (400) und das ferroelektrische Material (402) eine zusammengesetzte dielektrische Konstante im Bereich zwischen 2 und 100 bei Null Volt aufweisen.

7. Antenne (100) gemäß Anspruch 3, wobei das unveränderliche dielektrische Material (400) aus einem Material gebildet ist, das aus der Gruppe gewählt ist, die Keramik, FR4, Luft, Schaumstoff, MgO, Lanthanaluminat und Saphir aufweist.

8. Antenne (100) gemäß Anspruch 4, wobei das erste ferroelektrische Material (402) aus Barium-Strontium-Titanat, BaₓSr₁₋ₓ, TiO₃ (BSTO) gebildet ist.

9. Antenne (100) gemäß Anspruch 8, wobei das erste ferroelektrische Material (402) Oxid-Dotiersubstanzen aufweist, die aus der Gruppe ausgewählt sind, die Wolfram, Mangan und Magnesium aufweist.

10. Antenne (100) gemäß Anspruch 8, wobei die erste veränderliche dielektrische Konstante das verdoppelt in Antwort auf eine Änderung von weniger als 1 Volt einer Bias-Spannung.

11. Antenne (100) gemäß Anspruch 8, wobei die erste Kapazität (112, 1012) einen Kapazitätswert von ungefähr 0,35 Pikofarad (pF) bei Null Volt einer Bias-Spannung aufweist.

12. Antenne (100) gemäß Anspruch 11, wobei die erste Kapazität (112, 1012) einen Kapazitätswert von ungefähr 0,29 Pikofarad (pF) bei 40 Volt der Bias-Spannung aufweist.

13. Antenne (100) gemäß Anspruch 8, wobei die erste Kapazität (112, 1012) einen Kapazitätswert in dem Bereich von 0,1 bis 10 pF bei Null Volt aufweist.

14. Antenne (100) gemäß Anspruch 4, wobei das erste ferroelektrische Material (402) in einer dünnen Schicht mit einer Dicke in dem Bereich von 0,5 bis 2 Mikron gebildet ist.

15. Antenne (100) gemäß Anspruch 4, wobei das erste ferroelektrische Material (402) in einer dicken Schicht mit einer Dicke in dem Bereich von 1,5 bis 1000 Mikron gebildet ist.

16. Antenne (100) gemäß Anspruch 4, wobei die erste Kapazität (112, 1012) einen ersten Anschluss (306) aufweist, der mit dem zweiten Ende (108, 1008) des Strahlers gekoppelt ist, und einen zweiten Anschluss (308), der mit der Bias-Spannungs-Einspeisung (300) gekoppelt ist; und
wobei die Bias-Spannungs-Einspeisung (300) ein erstes Spannungspotential an die erste Kapazität (112, 1012) anlegt.

17. Antenne (100) gemäß Anspruch 16, wobei die erste Kapazität (112, 1012) aufweist:
eine erste Dielektrikumschicht (400) mit festgesetzter Konstante; und
ein ferroelektrisches Dielektrikum (402) mit einer veränderlichen dielektrischen Konstante benachbart zur ersten Dielektrikumschicht (400) mit fester Konstante.

18. Antenne (100) gemäß Anspruch 17, wobei das erste ferroelektrische Material (402) zwischen der ersten Dielektrikumschicht (400) mit festgesetzter Konstante und den Anschlüssen (306, 308) angeordnet ist.

19. Antenne (100) gemäß Anspruch 17, wobei das erste Dielektrikummaterial (400a) mit festgesetzter Konstante zwischen dem ferroelektrischen Material (402) und dem ersten Anschluss (306) angeordnet ist, und eine zweite Dielektrikumschicht (400b) mit fester Konstante zwischen dem zweiten Anschluss (308) und dem ferroelektrischen Material (402) angeordnet ist.

20. Antenne (100) gemäß Anspruch 17, wobei das erste ferroelektrische Material (402) innerhalb des ersten Dielektrikums (400) mit festgesetzter Konstante gebildet ist.

21. Antenne (100) gemäß Anspruch 17, wobei das erste ferroelektrische Material (402) außerhalb des ersten Dielektrikums (400) mit festgesetzter Konstante gebildet ist.

22. Antenne (100) gemäß Anspruch 16, ferner aufweisend:
eine Biasspannungs-Blockierkapazität (310), die zwischen dem zweiten Anschluss (308) der ersten Kapazität und dem Gegengewicht (102, 1002) angeordnet ist.

23. Antenne (100) gemäß Anspruch 16, wobei die erste Kapazität (112, 1012) eine Zwischenraum-Kapazität mit den ersten und zweiten Anschlüssen (306, 308) ist, die als von einem Zwischenraum getrennte Pads über einer Schicht aus einem ferroelektrischen Dielektrikum liegend, gebildet sind.

24. Antenne (100) gemäß Anspruch 23, wobei die erste Kapazität (112, 1012) die Schicht aus ferroelektrischem Dielektrikum (402) aufweist, die über einer Schicht (400) aus Dielektrikum mit festgesetzter Konstante liegt.

25. Antenne (100) gemäß Anspruch 16, wobei die erste Kapazität (112, 1012) eine Parallelplatten-Kapazität ist, wobei der erste Anschluss (306) als eine Platte über einer Schicht aus einem ferroelektrischen Dielektrikum (402) liegend, über einer Schicht (400) aus einem Dielektrikum mit festgesetzter Konstante liegend, über dem als Platte ausgebildeten zweiten Anschluss (308) liegend, gebildet ist.

26. Antenne (100) gemäß Anspruch 16, ferner aufweisend:
eine dritte Kapazität (310), die aus einem fünften Dielektrikum (400, 402) mit einem dritten ferroelektrischen Material (402), das eine dritte veränderliche dielektrische Konstante aufweist, gebildet ist, mit einem ersten Anschluss (312) der dritten Kapazität, die mit dem zweiten Anschluss (308) der ersten Kapazität gekoppelt ist, und einem zweiten Anschluss (314) der dritten Kapazität, die mit dem Gegengewicht (102, 1002) gekoppelt ist;
wobei die Bias-Spannungseinspeisung (300) ein Spannungspotential an die zweite Kapazität (310) anlegt; und
wobei die Antenne (100) auf der Resonanzfrequenz, die auf die dritte veränderliche Dielektrikumskonstante des dritten ferroelektrischen Materials (402) in Verbindung mit der ersten veränderlichen Dielektrikumskonstante des ferroelektrischen Materials (402) der ersten Kapazität reagiert, resonant ist.

27. Antenne (100) gemäß Anspruch 1, wobei die Kombination der ersten Kapazität (112, 1012) und des Strahlers (104, 1004) eine wirksame elektrische Wellenlänge einer λ/4-Länge der Resonanzfrequenz aufweist.

28. Antenne (100) gemäß Anspruch 1, wobei das erste Dielektrikum (110, 1000) aus einem Material gebildet ist, das aus der Gruppe ausgewählt ist, die Keramik, FR4, Luft, Schaumstoff, MgO, Lanthanaluminat und Saphir aufweist.

29. Antenne (100) gemäß Anspruch 1, wobei das zweite Dielektrikum ausschließlich aus dem ferroelektrischen Material (402) gebildet ist.

## Revendications

1. Antenne ferroélectrique en F inversé comprenant :
un contrepoids (102, 1002) ;
un radiateur en structure en F inversé (104, 1004) comportant une première extrémité (106, 1006) raccordée au contrepoids (102, 1002) et une deuxième extrémité (108, 1008) ;
un premier diélectrique (110, 1000) intercalé entre le radiateur (104, 1004) et le contrepoids (102, 1002) ;
**caractérisée par**
un premier condensateur (112, 1012) formé à partir d'un deuxième diélectrique (400, 402) avec un premier matériau ferroélectrique (402), ayant une première constante diélectrique variable, intercalé entre la deuxième extrémité de radiateur (108, 1008) et le contrepoids (102, 1002) ;
dans laquelle l'antenne (100) est résonante à une fréquence de résonance en réponse à la première constante diélectrique variable du premier matériau ferroélectrique (402) ;
une ligne de transmission ayant une première polarité de ligne de transmission (116) raccordée au radiateur (104, 1004), la ligne de transmission ayant une impédance caractéristique fixe prédéterminée indépendante de la fréquence de résonance de l'antenne (100) ;
un deuxième condensateur (700) formé à partir d'un troisième diélectrique avec un deuxième matériau ferroélectrique (402), ayant une deuxième constante diélectrique variable, intercalé entre la première polarité de ligne de transmission (116) et le radiateur (104) ; et
dans laquelle une impédance ajustable, orientée vers la ligne de transmission, telle qu'observée depuis le radiateur (104), est sensible à la deuxième constante diélectrique variable du deuxième matériau ferroélectrique (402).

2. Antenne (100) selon la revendication 1, dans laquelle l'antenne (100) présente un gain prédéterminé approximativement constant indépendant de la fréquence de résonance.

3. Antenne selon la revendication 1, dans laquelle le deuxième diélectrique (400, 402) du premier condensateur (112, 1012) comprend :
un quatrième diélectrique (400) formé à partir d'un matériau diélectrique fixe avec une constante diélectrique fixe.

4. Antenne (100) selon la revendication 1, comprenant en outre :
une alimentation en tension de polarisation (300) destinée à appliquer une tension appliquée au premier condensateur (112, 1012) ; et
dans laquelle la première constante diélectrique variable du premier matériau ferroélectrique (402) varie en réponse à la tension appliquée.

5. Antenne (100) selon la revendication 4, dans laquelle le premier matériau ferroélectrique (402) présente une première constante diélectrique variable dans la plage comprise entre 100 et 5 000 à zéro volt.

6. Antenne (100) selon la revendication 4, dans laquelle le matériau diélectrique fixe (400) et le matériau ferroélectrique (402) présentent une constante diélectrique composite dans la plage comprise entre 2 et 100 à zéro volt.

7. Antenne (100) selon la revendication 3 dans laquelle le matériau diélectrique fixe (400) est formé d'un matériau sélectionné dans le groupe comprenant la céramique, le FR4, l'air, la mousse, le MgO, l'aluminate de lanthane et le saphir.

8. Antenne (100) selon la revendication 4, dans laquelle le premier matériau ferroélectrique (402) est formé de titanate de strontium de baryum, BaₓSr₁₋ₓ, TiO₃ (BSTO).

9. Antenne (100) selon la revendication 8, dans laquelle le premier matériau ferroélectrique (402) comprend des dopants d'oxyde sélectionnés dans le groupe comprenant le tungstène, le manganèse et le magnésium.

10. Antenne (100) selon la revendication 8, dans laquelle la première constante diélectrique variable double en réponse à un changement de moins de 1 volt d'une tension de polarisation.

11. Antenne (100) selon la revendication 8, dans laquelle le premier condensateur (112, 1012) présente une capacitance d'environ 0,35 picofarad (pF) à zéro volt d'une tension de polarisation.

12. Antenne (100) selon la revendication 11, dans laquelle le premier condensateur (112, 1012) présente une capacitance d'environ 0,29 pF à 40 volts de tension de polarisation.

13. Antenne (100) selon la revendication 8, dans laquelle le premier condensateur (112, 1012) présente une capacitance dans la plage de 0,1 à 10 pF à zéro volt.

14. Antenne (100) selon la revendication 4, dans laquelle le premier matériau ferroélectrique (402) est formé dans une couche mince présentant une épaisseur dans la plage de 0,15 à 2 microns.

15. Antenne (100) selon la revendication 4, dans laquelle le premier matériau ferroélectrique (402) est formé dans une couche mince présentant une épaisseur dans la plage de 1,5 à 1 000 microns.

16. Antenne (100) selon la revendication 4, dans laquelle le premier condensateur (112, 1012) présente une première borne (306) raccordée à la deuxième extrémité de radiateur (108, 1008) et une deuxième borne (308) raccordée à l'alimentation en tension de polarisation (300) ; et
dans laquelle l'alimentation en tension de polarisation (300) applique un premier potentiel de tension en travers du premier condensateur (112, 1012).

17. Antenne (100) selon la revendication 16, dans laquelle le premier condensateur (112, 1012) comprend :
une première couche de diélectrique constant fixe (400) ; et
un diélectrique ferroélectrique (402) avec une constante diélectrique variable, adjacent à la première couche de diélectrique constant fixe (400).

18. Antenne (100) selon la revendication 17, dans laquelle le premier matériau ferroélectrique (402) est intercalé entre la première couche de diélectrique constant fixe (400) et les bornes (306, 308).

19. Antenne (100) selon la revendication 17, dans laquelle le premier matériau diélectrique constant fixe (400a) est intercalé entre le matériau ferroélectrique (402) et la première borne (306), et une deuxième couche de diélectrique constant fixe (400b) est intercalée entre la deuxième borne (308) et le matériau ferroélectrique (402).

20. Antenne (100) selon la revendication 17, dans laquelle le premier matériau ferroélectrique (402) est formé de façon interne au premier diélectrique constant fixe (400).

21. Antenne (100) selon la revendication 17, dans laquelle le premier matériau ferroélectrique (402) est formé de façon externe à la première couche de diélectrique constant fixe (400).

22. Antenne (100) selon la revendication 16, comprenant en outre :
un condensateur de blocage de tension de polarisation (310) intercalé entre la deuxième borne de premier condensateur (308) et le contrepoids (102, 1002).

23. Antenne (100) selon la revendication 16, dans laquelle le premier condensateur (112, 1012) est un condensateur d'écart ayant les première et deuxième bornes (306, 308) formées comme des patins, séparés par un écart, recouvrant une couche de diélectrique ferroélectrique.

24. Antenne (100) selon la revendication 23, dans laquelle le premier condensateur (112, 1012) comprend la couche de diélectrique ferroélectrique (402) recouvrant une couche (400) de diélectrique constant fixe.

25. Antenne (100) selon la revendication 16, dans laquelle le premier condensateur (112, 1012) est un condensateur à plaque parallèle ayant la première borne (306) formée comme une plaque, recouvrant une couche de diélectrique ferroélectrique (402), recouvrant une couche (400) de diélectrique constant fixe, recouvrant la deuxième borne (308) formée comme une plaque.

26. Antenne (100) selon la revendication 16, comprenant en outre :
un troisième condensateur (310) formé à partir d'un cinquième diélectrique (400, 402) avec un troisième matériau ferroélectrique (402) ayant une troisième constante diélectrique variable, avec une première borne de troisième condensateur (312) raccordée à la deuxième borne de premier condensateur (308) et une deuxième borne de troisième condensateur (314) raccordée au contrepoids (102, 1002) ;
dans laquelle l'alimentation en tension de polarisation (300) applique un potentiel de tension en travers du deuxième condensateur (310) ; et
dans laquelle l'antenne (100) est résonante à la fréquence de résonance en réponse à la troisième constante diélectrique variable du troisième matériau ferroélectrique (402) en combinaison avec la première constante diélectrique variable du matériau ferroélectrique de premier condensateur (402).

27. Antenne (100) selon la revendication 1, dans laquelle la combinaison du premier condensateur (112, 1012) et du radiateur (104, 1004) présente une longueur d'onde électrique effective d'un quart de longueur d'onde de la fréquence de résonance.

28. Antenne (100) selon la revendication 1, dans laquelle le premier diélectrique (110, 1000) est formé à partir d'un matériau sélectionné dans le groupe comprenant la céramique, le FR4, l'air, la mousse, le MgO, l'aluminate de lanthane et le saphir.

29. Antenne (100) selon la revendication 1, dans laquelle le deuxième diélectrique est formé exclusivement à partir du matériau ferroélectrique (402).
